(19) Europäisches Patentamt / European Patent Office / Office européen des brevets

(11) EP 4 592 077 A1

(12) DEMANDE DE BREVET EUROPEEN

(43) Date de publication:
**30.07.2025 Bulletin 2025/31**

(21) Numéro de dépôt: **25154659.4**

(22) Date de dépôt: **29.01.2025**

(51) Classification Internationale des Brevets (IPC):
***B32B 27/32*** *(2006.01)* ***C08F 255/02*** *(2006.01)*
***C08F 10/02*** *(2006.01)* ***C08J 3/24*** *(2006.01)*

(52) Classification Coopérative des Brevets (CPC):
(C-Sets disponibles)
**H10F 19/804; B32B 27/32; C08F 255/02; C08F 255/023; C08J 3/24;** C08F 2810/10; C08F 2810/20 (Cont.)

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **29.01.2024 FR 2400850**

(71) Demandeur: **Commissariat à l'Energie Atomique et aux Energies Alternatives**
**75015 Paris (FR)**

(72) Inventeurs:
- **BRASTEL, Alexis**
  **38054 Grenoble cedex 09 (FR)**
- **LANDA, Margot**
  **38054 Grenoble cedex 09 (FR)**
- **MOFAKHAMI, Eeva**
  **38054 Grenoble cedex 09 (FR)**
- **PILUSO, Pierre**
  **38054 Grenoble cedex 09 (FR)**

(74) Mandataire: **Gevers & Orès**
**Immeuble le Palatin 2**
**3 Cours du Triangle**
**CS 80165**
**92939 Paris La Défense Cedex (FR)**

# (54) ENCAPSULANT POLYMERE REVERSIBLE OU DYNAMIQUE POUR PANNEAU PHOTOVOLTAÏQUE PERMETTANT UN DEMANTELEMENT AMELIORE POUR FACILITER LA SEPARATION DES COMPOSANTS DU PANNEAU

(57) La présente invention concerne un encapsulant de module photovoltaïque, caractérisé en ce qu'il comprend,
- un polyoléfine formule (I), et
- un groupe disiloxane notamment un groupe dialkylsiloxane choisi parmi le diméthylsiloxane et le diéthylsiloxane, et/ou le polydialkylsiloxane de formule (II) comme réticulant ;
le polyoléfine représentant de 78 à 99,75% en masse, le réticulant de 0,25 à 22% en masse par rapport à la masse totale de la composition de l'encapsulant.

L'invention concerne l'utilisation d'un tel encapsulant dans un module photovoltaïque.

EP 4 592 077 A1

(52) Classification Coopérative des Brevets (CPC):
(Cont.)

C-Sets
**C08F 8/46, C08F 210/02;**
**C08F 8/46, C08F 210/16**

## Description

### Domaine technique de l'invention

L'invention concerne le domaine des polymères utilisés comme encapsulants de modules photovoltaïques pour panneaux photovoltaïques. En particulier, l'invention concerne l'utilisation d'un polymère réticulé via une chimie dynamique covalente comme encapsulant dans les modules photovoltaïques pour un démantèlement et un recyclage des différents composants du panneau facilité.

### Arrière-plan technique

Alors que le réchauffement climatique lié aux émissions anthropiques de gaz à effet de serre s'accélère, les sociétés actuelles requièrent un changement drastique de leurs manières de produire de l'énergie, et les énergies dites renouvelables émergent comme une solution viable à la production d'une énergie décarbonée. Parmi ces énergies renouvelables, l'énergie solaire est produite via la conversion des rayonnements solaires en électricité par des panneaux photovoltaïques. Si la méthode de production d'énergie est effectivement plus renouvelable que la combustion de ressources fossiles, il convient malgré tout, afin de limiter l'impact environnemental de la production d'énergie solaire, de limiter autant que possible l'impact, sur l'environnement et la disponibilité des ressources, des phases de production et de fin de vie des panneaux photovoltaïques.

Actuellement, la majorité des panneaux photovoltaïques sont constitués par un assemblage de plusieurs couches, qui constituent un module, et comprennent, de la couche axée vers le soleil à la couche support :

- un substrat transparent, généralement du verre de qualité optique ;
- une couche d'encapsulant ;
- les cellules photovoltaïques ;
- une autre couche d'encapsulant ;
- une couche protectrice supportant le tout (appelée également backsheet en anglais).

La composition d'un module photovoltaïque standard est illustrée en [Fig.1]. Le silicium est l'élément principal utilisé pour la fabrication de panneaux photovoltaïques. Le silicium a tendance à réagir au contact d'autres molécules, notamment de l'oxygène. Si l'encapsulant n'est pas de bonne qualité et ne joue pas efficacement son rôle de protection des modules de l'environnement et des éléments extérieurs (pluie, vent, etc.), les cellules de silicium entreront en contact avec de l'eau et/ou de l'air et le panneau commencera à s'oxyder. Le panneau perdra alors en efficacité et sera endommagé.

Le premier rôle de l'encapsulant est donc de protéger et d'isoler les modules de l'environnement et des éléments extérieurs (pluie, vent, etc.) et ainsi assurer leur fonctionnement sur des temps longs (aujourd'hui de l'ordre de 25 ans). Un module est fabriqué via un procédé dit de lamination permettant de combiner toutes les couches montrées en [Fig.1], en un seul bloc. Ce procédé consiste à fabriquer un sandwich avec les différents composants puis à appliquer une pression à chaud pour permettre une fusion/réticulation de la couche d'encapsulant. Les cellules photovoltaïques sont ainsi enrobées par l'encapsulant permettant de les isoler du milieu extérieur.

Le second rôle de l'encapsulant est de jouer le rôle d'adhésif entre les différents composants du module et d'assurer la stabilité dimensionnelle du panneau solaire. La couche protectrice face avant qui est un verre solaire ou la couche protectrice face arrière (backsheet) qui est souvent un multicouche de polymères présentant des propriétés barrières efficaces(valeur de vitesse de transmission de la vapeur d'eau se situant autour de 0.1 $g/m^2$/jour), ne doivent pas se délaminer au cours du temps et se détacher de l'ensemble. Actuellement, des résines réticulables, comme l'éthylène-acétate de vinyle ou EVA (ethylene-vinyl acetate en anglais), sont utilisées pour remplir le rôle d'encapsulant. Elles permettent une fusion en début de procédé, puis réticulent durant la chauffe pour figer le système et obtenir leurs propriétés finales : adhésion, stabilité thermique, chimique et mécanique. Si cette méthode a fait ses preuves pour les qualités des modules formés en terme de facilité et de coût de production et d'efficacité lors de la phase de production d'énergie, elle reste en revanche limitée lorsqu'est abordée la question de la fin de vie des modules. En effet, la nature réticulée de l'encapsulant l'empêche d'être fondu et de permettre une délamination facile des différentes couches des modules pour ensuite les traiter dans des flux séparés. L'étape de recyclage des panneaux passe donc souvent, à l'heure actuelle, par un broyage suivi d'une pyrolyse permettant une dégradation de la fraction organique (polymères des panneaux). Cette méthode est coûteuse en termes d'énergie émettrice de $CO_2$. Des procédés de séparations alternatifs sont en cours de développement avec une découpe précise de la couche d'encapsulant pour séparer les différents éléments. Néanmoins, ce type de procédé est difficile à mettre en oeuvre car l'épaisseur de l'encapsulant est faible (inférieure à 500 $\mu$m) et doit être ajustée à chaque technologie de panneau. Le recyclage des panneaux photovoltaïques, est pourtant essentiel d'un point de vue écologique et économique en raison des métaux rares présents dans les panneaux (argent, cuivre et dans une moindre mesure silicium). De plus, concernant le backsheet, un traitement séparé est nécessaire car cette couche contient souvent des polymères fluorés, de l'aluminium,etc. Après broyage/incinération ou séparation mécaniques, une récupération des métaux rares compris dans les cellules photovoltaïques par des procédés hydrométallurgiques ou pyrométallurgiques est possible. Ces voies de recyclages sont coûteuses car les différents composés doivent être extraits et purifiés

avant de pouvoir être de nouveaux valorisés.

Afin de pallier à ce problème, des encapsulants thermoplastiques ont été développés récemment. Ces encapsulants étant non réticulés, un procédé thermique ou chimique permet d'envisager une délamination des panneaux en fin de vie de manière aisée. Une mise en température des panneaux au-dessus de la température de fusion de ces polymères permet de faire passer le polymère à l'état fondu et ainsi permettre la séparation des différentes couches des modules. Une autre solution est de passer par une voie solvant pour dissoudre l'encapsulant et séparer les différentes couches du panneau. Ces procédés de séparation peuvent se faire à des températures modérées (60-120°C) et si un recyclage du solvant est prévu pour les procédés en voie solvant, une consommation énergétique et un impact environnemental plus faible est attendu. Néanmoins, ce type de système s'éloigne des systèmes EVA réticulés aux propriétés idéales et possèdent de moindres propriétés techniques (stabilité thermique, mécanique et chimique).

Des systèmes plus complexes d'encapsulant peuvent être envisagés. Par exemple, ajouter une couche de thermoplastique entre deux films d'EVA réticulé ou une couche de thermoplastique de part et d'autre d'une couche d'EVA réticulé au contact de la cellule de silicium et du verre ou de la cellule de silicium et du backsheet. Ce type de technologie permet d'obtenir des encapsulant plus efficaces tout en assurant une meilleure séparation des différents composants du panneau en fin de vie. Néanmoins, après cette séparation, une couche d'EVA résiduelle est présente sur les différents composants, couche aussi complexe à traiter que dans le cas des systèmes EVA classique. La production de ce type d'encapsulant est également plus complexe car deux polymères distincts sont par essence incompatibles. La production de ce multicouche nécessite des équipements de plasturgie complexes et produit sur le marché un nouveau type de matériau qui ne va pas pouvoir être recyclé. En effet, le mélange de deux polymères conduit à une chute drastique des propriétés lors du recyclage en raison de la séparation de phase induite. L'ensemble de ces points freine la mise sur le marché de ces encapsulants, malgré l'avantage important offert en fin de vie comparé aux résines réticulables.

Il existe donc un réel besoin de disposer d'un encapsulant de module photovoltaïque ayant la qualité, les performances, les propriétés finales d'une couche de résine réticulable thermoplastique comme l'EVA, notamment en termes d'adhésion, de stabilité thermique, chimique et mécanique, tout en permettant en plus un démantèlement et un recyclage aisés des différents composants du module et du panneau photovoltaïque, comme les résines thermoplastiques.

En particulier, il existe toujours un besoin d'un encapsulant de module photovoltaïque ayant l'ensemble des propriétés susmentionnées, et en outre une facilité de mise en oeuvre lors de l'étape de lamination du module photovoltaïque, des bonnes propriétés optiques (transparence, faible niveau de Haze et d'indice de réfraction), une parfaite adhésion sur différents supports, une bonne tenue au fluage pour une température supérieure à 80°C, une faible perméabilité à l'eau, une bonne résistance aux UV (UltraViolet), une bonne isolation électrique.

**Résumé de l'invention**

La présente invention a précisément pour but de répondre à ce besoin, en fournissant un encapsulant de module photovoltaïque, caractérisé en ce qu'il comprend,

- un polyoléfine formule (I)

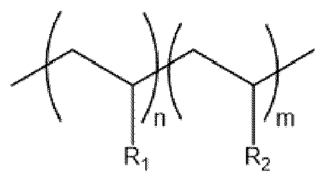

dans laquelle

n = 1 à 100%,
m = (100 - n)%,
$R_1$ et $R_2$, identiques ou différents, représentent un atome d'hydrogène, un groupe alkyle comportant 1 à 24 atomes de carbone, un groupe cycloalkyle comportant 3 à 24 atomes de carbone, les groupes alkyle, cycloalkyle étant éventuellement substitués, ledit polyoléfine ayant

. un indice de fluidité à chaud (appelé également IFC) supérieur à 0,1 g/10min et inférieur à 50g/10min (norme iso 1133-1 (2011)), 190°C, 2,16 Kg), et
. un taux de cristallinité massique inférieur à 30% ;

- un groupe disiloxane notamment un groupe dialkylsiloxane choisi parmi le diméthylsiloxane et le diéthylsiloxane, et/ou le polydialkylsiloxane de formule (II) :

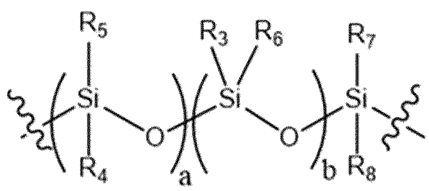

dans laquelle

- a = 1 à 100%,
- b = (100 - a)%, et

- le nombre d'unité de répétition Si-O-Si est compris entre 1 (dialkylsiloxane) et 5000,
- $R_3$ représente un groupe méthyle, un groupe éthyle ou

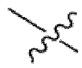

qui est le point d'attache de $R_3$ au polyoléfine par une liaison covalente,
- $R_4$, $R_5$, $R_6$, $R_7$, et $R_8$, identiques ou différents, représentent un groupe méthyle ou un groupe éthyle,

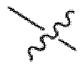

représente le point d'attache du polydialkylsiloxane au polyoléfine par une liaison covalente, comme réticulant ;

le polyoléfine représentant de 78 à 99,75% en masse, le réticulant de 0,25 à 22% en masse par rapport à la masse totale de la composition de l'encapsulant.

L'invention consiste à utiliser, comme encapsulant, un polymère réticulé présentant des liens covalents dynamiques et/ou réversibles dans sa structure, permettant la séparation aisée de l'encapsulant et de l'ensemble des constituants des panneaux photovoltaïques, ou une nouvelle lamination pour réassembler un matériau ayant subi une dégradation.

En effet, les systèmes actuels basés sur l'EVA sont réticulés de manière covalente et irréversible grâce à des agents de réticulation activés thermiquement (peroxydes notamment), ou par exposition aux UVs mettant en oeuvre une réticulation radicalaire. Par conséquent, sur les panneaux actuels une délamination est un phénomène irréversible et conduit à la mise au rebut des panneaux dégradés.

Récemment, l'utilisation de la chimie covalente dynamique et de la chimie covalente réversible a permis de mettre au point des systèmes polymères réticulés pouvant être remis en forme sous stimuli de température (à partir d'une température seuil) via la dynamique ou la réversibilité des liaisons chimiques. Les systèmes dynamiques permettent de conserver un taux de réticulation constant, tout en permettant la remise en forme des systèmes à chaud via des réactions d'échange.

Les systèmes réversibles permettent une rupture des liaisons covalentes à partir d'une certaine température seuil et donc impliquent une diminution du taux de réticulation passé cette température. La différence majeure entre système associatif et système dissociatif est l'évolution de la viscosité en fonction de la température. La viscosité des systèmes associatifs suit une loi d'Arrhénius en fonction de l'inverse de la température, comportement similaire au verre, contrairement au système dissociatif dont la viscosité chute de manière brutale passé la température de dissociation.

Dans le cadre de la présente invention, une chimie mettant en jeu un système associatif ou dissociatif ou un mélange associatif/dissociatif, peut être utilisée pour mettre au point un polymère réticulé de manière dynamique réversible afin d'obtenir un réseau polymère possédant des propriétés équivalentes aux systèmes EVA actuels, tout en assurant une séparabilité de l'ensemble des constituants ou en offrant la possibilité de remettre en forme le matériau en fin de vie des panneaux.

Ainsi, un encapsulant selon l'invention peut présenter un double objectif :

- prolonger la durée de vie des panneaux solaires en permettant une relamination de panneaux ayant subi une délamination ; et
- faciliter la séparation des différents constituants en s'appuyant sur la réversibilité des liens chimiques employés.

Le principe d'un réseau réticulé avec des chimies dynamiques ou réversibles et les différences au niveau mécanistique que cela implique sont représentés en [Fig.2].

Différentes voies existent pour obtenir des réseaux réticulés de manière réversible ou dynamique. Quelques-unes de ces voies sont présentées en [Fig.3]. Comme on peut le voir, la réticulation s'appuie sur la fonctionnalisation des matériaux polymères (soit lors de la polymérisation soit lors d'une étape de post-polymérisation). Dans le cas des polyoléfines de formule (I), cette fonctionnalisation est souvent réalisée en masse par une chimie de greffage radicalaire. Les fonctions chimiques gris foncé et noire sur le schéma désignent respectivement des chimies covalentes dynamiques ou réversibles et une chimie covalente classique. Une température caractéristique du réseau polymère est associée à la présence de chimie dynamique ou réversible à partir de laquelle la chimie dynamique ou réversible sera activée, et le matériau sera malléable. Dans le cas d'une chimie réversible, le dépassement de la température de dissociation $T_d$ permet de déréticuler le réseau et d'obtenir un thermoplastique non réticulé. Alors que les systèmes réticulés dynamiques réversibles possèdent une $T_d$ qui va s'apparenter à une fusion dans le comportement viscoélastique du polymère (rupture des liaisons et fusion), les systèmes dynamiques associatifs eux ne possèdent pas de changement de comportement type déréticulation ou analogue, qui induit un changement brutal de comportement viscoélastique.

Dans le cas d'une chimie dynamique, les liaisons s'échangent de manière associative et donc sans diminution du taux de réticulation, ce qui rend la diminution de viscosité moins brutale (la viscosité évoluant alors linéairement avec l'inverse de la température). Il n'existe pas de température au-delà de laquelle les comportements changent brutalement de propriétés. Dans ces cas, la température de procédé employé est définie de

manière arbitraire en fonction des caractéristiques souhaitées en terme de viscosité et de reprocessabilité. Par reprocessabilité, on entend une remise en forme rapide sans dégradation du polymère.

Pour les chimies dynamiques, on peut citer la chimie des échanges de siloxanes, comme montré en [Fig.4]. [Fig.4] montre que l'échange dynamique de groupements siloxanes se fait sans rupture de liaisons. Le polymère initial présente un indice de fluidité à chaud (appelé également IFC) supérieur à 0,1g/10min et inférieur à 50g/10min (norme iso 1133-1 (2011)), 190°C, 2,16 Kg) afin d'avoir des systèmes peu visqueux au départ, à laquelle on greffe de manière covalente un composé réticulant porteur de liaisons chimiques covalentes réversibles ou dynamiques. Ce composé réticulant a une fonctionnalité de 2 ou plus afin de permettre la formation d'un réseau entre les chaînes de polymère.

Le greffage du composé réticulant aux chaînes de polymères peut se faire par plusieurs voies qui divergent par les conditions de synthèse.

La synthèse du réseau dynamique ou réversible de polymère se fait en une étape ou en deux étapes.

La synthèse en une étape se fait généralement en masse (dans un procédé d'extrusion réactive) et consiste à réticuler des polyoléfines ne présentant pas de fonctions réactives au départ. La réticulation se produit en faisant réagir une molécule présentant une fonctionnalité supérieure ou égale à 2 par voie radicalaire en utilisant un générateur de radicaux (peroxyde par exemple) et présentant dans sa structure chimique une liaison dynamique ou réversible.

La synthèse en deux étapes consiste à fonctionnaliser le polymère de type polyoléfine par introduction de fonctions réactives le long de la chaîne polymère dans un premier temps, avant de procéder à l'étape de réticulation au cours de laquelle les fonctions réactives réagissent avec une molécule présentant une fonctionnalité supérieure ou égale à 2 dans un second temps. La première étape peut être effectuée directement lors de la synthèse du polymère en réalisant une copolymérisation (par exemple éthylène et un autre monomère d'intérêt présentant une fonction vinylique) ou par post fonctionnalisation d'un polymère non fonctionnel par voie radicalaire. Une fois ce polymère fonctionnalisé synthétisé, l'introduction d'un composé réticulant conduit à l'obtention du réseau polymérique. Le composé réticulant est une molécule présentant une fonctionnalité supérieure ou égale à 2 et pouvant réagir avec les fonctions réactives du polymère. La dynamique ou la réversibilité du réseau polymérique ainsi obtenu provient de la structure chimique du composé réticulant. En effet, celui-ci doit présenter dans sa structure la liaison dynamique ou réversible d'intérêt. Cette voie de réticulation peut se faire directement en extrusion (et par conséquent en masse) ou en voie solvant. Ces voies et conditions de synthèse sont bien connues de l'homme du métier et décrit, par exemple, dans « The synthesis of polyolefin graft copolymers by reactive extrusion » (Prog. Polym. Sci., 1999, 24, 81-142**).**

Les chimies de greffage permettant de greffer des fonctionnalités à des polyoléfines par voies radicalaires sont diverses : anhydride maléique, maléimides, vinyles, (méth)acrylates, etc.

Les chimies d'échanges possiblement applicables aux polymères de l'invention sont très nombreuses également (réversible ou dynamique) : siloxane, imine, pont disulfure, ester, ester boronique, métathèse, etc. L'invention a également pour objet, l'utilisation d'un encapsulant de l'invention, dans un module photovoltaïque.

Un autre objet de l'invention est un module photovoltaïque comprenant

- un substrat transparent, correspondant souvent à un verre solaire présentant les caractéristiques suivantes : une faible réflexion, une haute transmissivité et une haute résistance.
  Les verres utilisés sont soit des verres cristallins (mono ou polycrystallins), soit des verres à couches minces. Les verres sont parfois recouverts d'un revêtement afin de diminuer leur réflexion et à faible teneur en Fe, afin d'obtenir des valeurs de transparences élevées connues sous le nom de verre à faible teneur en fer ou verre ultra-blanc,
- une couche d'encapsulant selon l'invention,
- une cellule photovoltaïque, notamment à base de silicium, de séléniure de cuivre-indium ($CuIn(Se)_2$, ou CIS), de séléniure de cuivre, indium et de gallium ($CuInGa(Se)_2$, aussi appelé CIGS), ou de tellure de cadmium (CdTe),
- une autre couche d'encapsulant selon l'invention,
- une couche protectrice supportant le tout (backsheet), notamment en polyfluorure de vinylidène (PVDF), poly(oxyde de p-phénylène) (PPO) ou poly(éther de p-phénylène) (PPE), poly(téréphtalate d'éthylène) (PET), chlorure de polyvinyle (PVC), ou élastomère thermoplastique (TPE) ou en verre.

## Brève description des figures

D'autres caractéristiques et avantages de l'invention apparaitront au cours de la lecture de la description détaillée qui va suivre pour la compréhension de laquelle on se reportera aux dessins annexés dans lesquels :

[Fig.1] représente la composition d'un module photovoltaïque standard.

[Fig.2] est un schéma représentatif d'un système polymère porteur de liaisons chimiques réversibles et dynamiques.

[Fig.3] représente les voies de synthèse des réseaux polymères à liens covalents dynamiques ou réversibles.

[Fig.4] représente l'échange dynamique (sans rupture de liaisons) de groupements disiloxanes.

[Fig.5] représente schématiquement la réaction de

greffage d'un groupement allyle sur une chaîne de polyéthylène (PE) par voie radicalaire.

[Fig.6] représente schématiquement la réaction de greffage d'anhydride maléique sur une chaîne de polyéthylène (PE) par voie radicalaire suivie d'une réaction avec une amine primaire.

[Fig.7] représente les courbes ADM en haut et les résultats des tests de gonflement (taux de gonflement et fraction insoluble) après 48h à 110°C dans du xylène de l'encapsulant de l'exemple 1 sans catalyseur et avec 0,08% massique de catalyseur en bas.

[Fig.8] représente montre le résultat de fluage recouvrance du matériau de l'exemple 1 sans catalyseur et avec 0,08% massique de catalyseur.

[Fig.9] représente l'ensemble des étapes du test de lamination/délamination/relamination effectué pour démontrer le potentiel de d'un encapsulant selon l'invention pour allonger la durée de vie des panneaux solaires ou faciliter leur démontabilité en fin de vie. Les différentes étapes sont regroupées sous forme de photographies.

## Description détaillée de l'invention

La présente invention concerne un encapsulant de module photovoltaïque, caractérisé en ce qu'il comprend,
caractérisé en ce qu'il comprend,

- un polyoléfine formule (I)

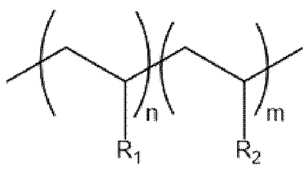

dans laquelle

n = 1 à 100%,
m = (100 - n)%,
$R_1$ et $R_2$, identiques ou différents, représentent un atome d'hydrogène, un groupe alkyle comportant 1 à 24 atomes de carbone, un groupe cycloalkyle comportant 3 à 24 atomes de carbone, les groupes alkyle, cycloalkyle étant éventuellement substitués, ledit polyoléfine ayant

. un indice de fluidité à chaud (appelé également IFC) supérieur à 0,1 g/10min et inférieur à 50g/10min (norme iso 1133-1 (2011)), 190°C, 2,16 Kg), et
. un taux de cristallinité massique inférieur à 30% ;

- un groupe disiloxane notamment un groupe dialkylsiloxane choisi parmi le diméthylsiloxane et le diéthylsiloxane, et/ou le polydialkylsiloxane de formule (II) :

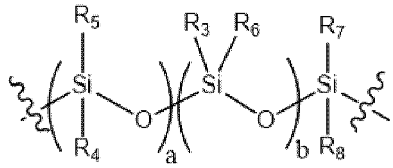

dans laquelle

- a = 1 à 100%,
- b = (100 - a)%, et
- le nombre d'unité de répétition Si-O-Si est compris entre 1 (dialkylsiloxane) et 5000,
- $R_3$ représente un groupe méthyle, un groupe éthyle ou

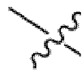

qui est le point d'attache de $R_3$ au polyoléfine par une liaison covalente,
- $R_4$, $R_5$, $R_6$, $R_7$, et $R_8$, identiques ou différents, représentent un groupe méthyle ou un groupe éthyle,

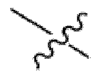

représente le point d'attache du polydialkylsiloxane au polyoléfine par une liaison covalente, comme réticulant ;

le polyoléfine représentant de 78 à 99,75% en masse, le réticulant de 0,25 à 22% en masse par rapport à la masse totale de la composition de l'encapsulant.

L'encapsulant de l'invention comprend donc un polymère linéaire de type polyoléfine (polyéthylène, PE, ou polypropylène, PP) de formule (I).

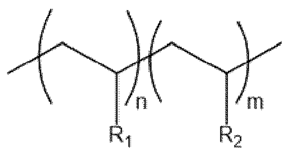

$R_1$ et $R_2$, identiques ou différents, représentent un atome d'hydrogène, un groupe alkyle comportant 1 à 24 atomes de carbone, un groupe cycloalkyle comportant 3 à 24 atomes de carbone, les groupes alkyle, cycloalkyle étant éventuellement substitués, est réticulé par des groupes disiloxanes.

Sauf indication contraire, dans la présente description, les indices m, n, a, et b sont des nombres réels positifs qui ne sont pas forcément entiers mais représentatifs de la structure moléculaire moyenne en pourcentage (valeurs statistiques).

On entend par « alkyle », au sens de la présente invention, un radical carboné linéaire, ramifié, saturé, éventuellement substitué, comprenant 1 à 24 atomes de carbone, de préférence 1 à 12 atomes de carbone. A titre d'alkyle saturé, linéaire ou ramifié, on peut citer par exemple les radicaux méthyle, éthyle, propyle, butyle, pentyle, hexyle, octyle, nonyle, décyle, undécyle, dodécanyle et leurs isomères ramifiés.

On entend par « cycloalkyle » un radical carboné mono- ou poly-cyclique, saturé, éventuellement substitué, comprenant 3 à 24 atomes de carbone, de préférence 3 à 12 atomes de carbone. Comme radical alkyle cyclique, saturé, on peut citer les radicaux cyclopropyle, cyclobutyle, cyclopentyle, cyclohexyle, bicylco [2,1,1] hexyle, bicyclo[2,2,1] heptyle, bicyclo[3.3.1]nonane.

Les radicaux alkyle, cycloalkyle peuvent être éventuellement substitués par un ou plusieurs atomes d'halogène choisis parmi les atomes de fluor, chlore, brome et iode; un ou plusieurs groupes nitro ($-NO_2$) ; un ou plusieurs groupes nitrile (-CN); un ou plusieurs groupes alkyle, avec alkyle tel que défini dans le cadre de la présente invention.

Dans le cadre de la présente invention, par groupe « disiloxane » on entend notamment un groupe dialkylsiloxane choisi parmi un groupe diméthylsiloxane et diéthylsiloxane, et/ou polyalkylsiloxane de formule (II) :

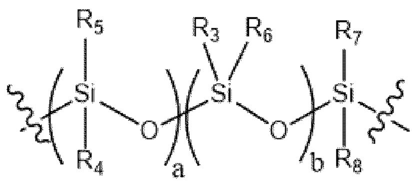

dans laquelle

- a = 1 à 100%,
- b = (100 - a)%, et
- le nombre d'unité de répétition Si-O-Si est compris entre 1 (dialkylsiloxane) et 5000,
- $R_3$ représente un groupe méthyle, un groupe éthyle ou

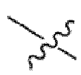

qui est le point d'attache de $R_3$ au polyoléfine par une liaison covalente,
- $R_4$, $R_5$, $R_6$, $R_7$, et $R_8$, identiques ou différents, représentent un groupe méthyle ou un groupe éthyle,

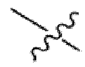

représente le point d'attache du polydialkylsiloxane au polyoléfine par une liaison covalente.

Selon un mode de réalisation préféré, le polyoléfine est choisi parmi

- le polyéthylène basse densité linéaire (PEBDL ou LLDPE de Linear low-density polyethylene en anglais). Sa densité est 0,92 g/cm$^3$.
- le polyéthylène à basse densité (PEBD ou LDPE de low density polyethylene en anglais). PEBD est celui comportant le plus de ramification entrainant une structure moléculaire moins compacte et donc une densité moindre. Il a une densité de 0,910 au 0,925 g/cm$^3$.
- le polypropylène (PP). Il a une densité entre 0,895 g/cm$^3$ et 0,92 g/cm$^3$.

La densité des polyoléfines est déterminée selon la norme ASTM D 1505.

Le polyoléfine est choisi avec une viscosité basse pour l'étape de démantèlement. Idéalement, l'indice de Fluidité à Chaud (IFC) à 190°C du polyoléfine est supérieur à 0,1 g/10 min.

Dans un mode de réalisation de l'invention, l'indice de Fluidité à Chaud (IFC) (ou Melt Flow Index (MFI) en anglais) à 190°C du polyoléfine de formule (I) peut être supérieur à 0,1 et inférieur à 50 g/10min (norme iso 1133-1 (2011)), 190°C, 2,16 Kg.

Dans un autre mode de réalisation de l'invention, l'indice de Fluidité à Chaud (IFC) du polyoléfine de formule (I) peut être de 14 g/10min.

Le polyoléfine de formule (I) présente un taux de cristallinité massique inférieur à 30%, en particulier inférieur à 20%.

Le taux de cristallinité massique d'un échantillon de polymère cristallisé est défini par le rapport de la masse des phases cristallines à la masse de l'échantillon étudié exprimé en %. La diffractométrie de rayons X, la calorimétrie différentielle à balayage (mesure des enthalpies de fusion), la densimétrie (mesure de densité au moyen d'un pycnomètre, ou avec des colonnes à gradient, cette dernière méthode est souvent utilisée pour la mesure de la densité des polyoléfines) la résonance magnétique nucléaire (RMN) large bande et la spectroscopie infra rouge (IR) sont les principales techniques physiques pour mesurer le taux de cristallinité d'un polymère. Dans la présente invention, le taux de cristallinité massique du polyoléfine a été déterminé par calorimétrie différentielle à balayage (Differential Scanning Calorimetry ou DSC en anglais).

Le polyoléfine de formule (I) est fonctionnalisé avec des groupements possédant une chimie dynamique ou réversible. Les chimies dynamiques ou réversibles utilisées peuvent être variées. Dans le cadre de la

présente invention, la chimie des échanges de siloxanes est choisie préférentiellement. Cette chimie, illustrée en [Fig.4], peut être utilisée afin de faciliter la formulation des encapsulants de l'invention en jouant notamment le rôle de promoteur d'adhésion. Pour cela, un groupe disiloxane, notamment un groupe dialkylsiloxane choisi parmi le diméthylsiloxane et le diéthylsiloxane, et/ou polyalkylsiloxane, doit être intégré au polymère initial. Le groupe disiloxane peut être intégré et greffé au polyoléfine via plusieurs précurseurs. Ces précurseurs peuvent être choisis parmi le 1,3-bis(3-glycidyloxypropyl) tétraméthyldisiloxane, le 1,3-divinyltétraméthyldisiloxane, le 1,3-bis(3-aminopropyl)tétraméthyldisiloxane, le 1,3-diallyltétraméthyldisiloxane, le 1,3-bis(chloropropyl)tétramethyldisiloxane, le 1,3-bis(hydroxypropyl)tétraméthyldisiloxane, dont le greffage aboutit à un polyalkylsiloxane de formule (II)

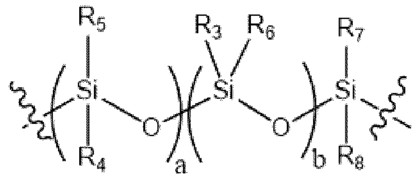

dans laquelle

- a = 1 à 100%,
- b = (100 - a)%, et
- le nombre d'unité de répétition Si-O-Si est compris entre 1 (dialkylsiloxane) et 5000,
- $R_3$ représente un groupe méthyle, un groupe éthyle ou

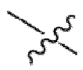

qui est le point d'attache de $R_3$ au polyoléfine par une liaison covalente,

- $R_4$, $R_5$, $R_6$, $R_7$,et $R_8$, identiques ou différents, représentent un groupe méthyle ou un groupe éthyle,

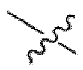

représente le point d'attache du polydialkylsiloxane au polyoléfine par une liaison covalente.

L'ensemble de ces précurseurs possède un ou plusieurs groupe(s) disiloxane(s) central(aux), ainsi que deux fonctions réactives en bout de chaîne, qui peuvent être utilisées pour être greffées au polyoléfine. Selon les deux fonctions réactives en bout de molécule, les voies de greffage au polyoléfine peuvent varier.

Par exemple, si les fonctions réactives sont des groupements allyles, 1,3-diallyltétraméthyldisiloxane par exemple, le greffage pourra se faire sans intermédiaire par voie radicalaire, en présence d'un initiateur de radicaux. Selon un mode de réalisation de l'invention, le polyoléfine est LLDPE. La [Fig.5] montre la réaction de greffage d'un groupement allyle sur une chaîne de polyéthylène par voie radicalaire.

Un initiateur est un composé qui se décompose pour amorcer et propager des réactions chimiques par génération de radicaux qui vont ensuite se transférer sur les chaines du polyoléfine et ainsi permettre le greffage de molécules par réaction radicalaire avec les fonctions réactives, par exemple avec les vinyles des polydiméthylsiloxanes fonctionnalisés vinyles pour la réticulation du polyoléfine greffé. L'homme du métier connaît bien les initiateurs et est en mesure de les fabriquer.

Dans le cadre de la présente invention, l'initiateur peut être choisi parmi

- un peroxyde choisi parmi le peroxyde de diisopropyle, peroxyde de dicumyle (DCP) (appelé également peroxyde de bis(1-phényl-1-méthyléthyl) ;
- un composé azoté choisi parmi le 2,2'azo-bis(2-méthylpropionitrile), l'azobisisobutyronitrile (AIBN).

Si les fonctions sont des $NH_2$ ou des OH, par exemple dans le cas du ,3-bis(hydroxypropyl)tétraméthyldisiloxane et du 1,3-bis(3-aminopropyl)tétraméthyldisiloxane), il peut être nécessaire de réaliser une étape intermédiaire, consistant préférentiellement à incorporer un groupement réactif au sein du polyoléfine, par exemple le LLDPE, notamment via une réaction avec l'anhydride maléique, largement décrite dans la littérature. Le polymère ainsi obtenu sera réactif vis-à-vis des fonctions $NH_2$ ou OH. La [Fig.6] montre une réaction de greffage d'anhydride maléique sur une chaîne de polyéthylène par voie radicalaire suivie d'une réaction avec une amine secondaire.

Selon un mode de réalisation, le réticulant peut représenter de 0,25 à 10% en masse par rapport à la masse totale de la composition de l'encapsulant. Selon un autre mode de réalisation, le réticulant peut représenter de 1 à 10% en masse par rapport à la masse totale de la composition de l'encapsulant. Dans le cas de la chimie d'échanges de siloxane et dans le cas d'autres chimies dynamiques covalentes, il peut être nécessaire d'avoir un composé servant de catalyseur au sein du polymère. Par « catalyseur au sein du polymère » on entend une molécule libre active chimiquement (ici le catalyseur) qui se trouve au sein du polymère ou greffée sur le polymère (ici le polymère étant le polyoléfine de formule (I)). Dans le cas présent, il est possible d'utiliser notamment des bases organiques à base d'amines ternaires, choisies dans le groupe consistant en le 1,5,7-triazabicyclo[4.4.0]dec-5-ène, le 1,5-diazabicyclo[4.3.0]non-5-ène, le 1,8-diazabicyclo[5.4.0]undec-7-ène, le 1,4-diazabicyclo[2.2.2]octane, et la 1,1,3,3-tétraméthylguanidine. Il est également possible d'utiliser un ammonium quaternaire choisi dans le groupe consistant en l'hydroxyde de tétraméthylammonium et les silanolates de tétraméthylammonium. Afin de réduire la toxicité du matériau et sa

dangerosité pour l'environnement, d'autres bases choisies dans le groupe consistant en KOH, et triméthylsilalonate de potassium, etc. peuvent être incorporées afin de jouer le rôle de catalyseur. D'autres catalyseurs existent tels que les acides de Bronsted mais ceux-ci compromettent la durabilité des panneaux solaires car ils peuvent provoquer de la corrosion acide à long terme dans les modules. Les acides de Lewis sont également promoteur de la réaction d'échange des fonctions siloxanes. Les acides de Lewis peuvent être choisi parmi les sels métalliques tels que le trifluorométhanesulfonate de zinc (également appelé triflate de zinc) ou le trifluorométhanesulfonate de scandium (également appelé triflate de scandium).

Le chargement en catalyseur peut aller jusqu'à 10 % en masse du polyoléfine. Selon un mode de réalisation de l'invention, le chargement en catalyseur est compris entre 0,01 et 10% en masse du polyoléfine. Selon un autre mode de réalisation, le chargement en catalyseur est inférieure à 1% en masse du polyoléfine.

L'encapsulant de l'invention peut comprendre, en outre, des additifs choisis dans le groupe consistant en des promoteurs d'adhésion, des antioxydants, des absorbeur d'UV.

Le promoteur d'adhésion peut être le vinyltriméthylsilane. La concentration du promoteur d'adhésion dans le mélange peut être de 0,1 à 10% en masse, plus particulièrement entre 0,5 et 3,5% en masse par rapport à la masse de polyoléfine.

L'antioxydant peut être un HALS (appelé photostabilisants à amines stériquement encombrées, ou Hindered Amine Light Stabilizer en anglais). Ces antioxydants sont des piégeurs de radicaux libres créés par les réactions avec la lumière UV.

A ce titre on peut citer par exemple, Tinuvin® 770. La concentration de l'antioxydant dans le mélange peut être inférieure à 5% en masse par rapport à la masse de polyoléfine.

Outre l'antioxydant, dans la première phase, le mélange peut comprendre un absorbeur d'UV comme par exemple Cyasorb® UV 531, avec une concentration inférieure à 5% en masse par rapport à la masse de polyoléfine.

Les chimies covalentes dynamiques citées ne sont pas exhaustives et une multitude d'autres chimies est envisageable.

Parmi les autres chimies covalentes dynamiques pouvant être utilisées, on peut citer notamment :

- la chimie d'échanges de ponts disulfures,
- les échanges d'esters boroniques,
- la chimie de transestérification, ou
- la chimie d'échange d'acétal.

Le polyoléfine réticulé de l'invention peut être préparé par des procédés de production classique pour les polymères en milieu fondu et en continu comme l'extrusion pour être ensuite laminés en film de l'épaisseur désirée en sortie d'extrusion ou dans une étape dédiée, puis utilisés comme encapsulant dans les panneaux photovoltaïques. Par exemple, le polyoléfine entrant dans la composition de l'encapsulant de l'invention peut être fabriqué par un procédé d'extrusion réactive. On peut réaliser ce mélangeage réactif dans une extrudeuse bi-vis de préférence co-rotatives ou en variante contre-rotatives, ou encore de préférence dans une extrudeuse mono-vis. On peut ainsi co-extruder le polyoléfine de formule (I), le précurseur de disiloxane et éventuellement un initiateur de réaction bien connu de l'homme du métier à une température comprise entre 70 et 140°C pour les mélanger, puis, déclencher la réaction du réticulant grâce à l'éventuel initiateur de réaction avec le polyoléfine à une température comprise entre 150 et 200°C, optionnellement complété par un catalyseur, un promoteur d'adhésion, un antioxydant, d'un absorbeur d'UV, afin de corréler la cinétique de réticulation du polyoléfine au profil de vis de l'extrudeuse et au temps de séjour du mélange dans cette extrudeuse.

La température optimale de mélange peut aller de 70°C à 140°C.

La température optimale de réaction correspondant à la réticulation peut être comprise entre 150°C et 200°C.

Il est favorable de faire une étape de mélange à basse température pour ne pas déclencher la réaction de fonctionnalisation et de réticulation, atteindre un milieu fondu homogène, puis dans un deuxième temps déclencher la réaction de fonctionnalisation et de réticulation à haute température. Idéalement, le mélangeage et la réaction de réticulation ont lieu dans la même extrudeuse.

Dans ce procédé, il y a au moins une phase avec un temps de séjour pouvant être compris entre 30 secondes et 30 minutes et une température de réaction comprise entre 165°C et 185°C. Plus particulièrement, le temps de séjour optimal est de 10 secondes à 10 minutes pour une température de réaction comprise entre 165°C et 180°C.

Ces procédés sont décrits dans l'état de la technique et bien connus de l'homme du métier.

Le promoteur d'adhésion, l'antioxydant et l'absorbeur d'UV sont tels que décrits précédemment dans le cadre de cet exposé.

La mise en forme en panneau photovoltaïque d'un encapsulant selon l'invention se fait à une température au moins supérieure à celle de fusion du polymère de base. En fin de vie des panneaux solaires, le polyoléfine réticulé dynamiquement peut être fondu à nouveau en le portant à haute température (supérieure à la température de fusion du polyoléfine de base), activant la dynamique des chaînes.

L'encapsulant selon l'invention présente les propriété suivantes :

- un module de stockage (E') supérieur au module de perte (E") sur toutes les températures (hors dégradation du polymère), soit E'>E" sur toutes T (hors dégradation), pouvant être mesuré en ADM ou en rhéologie,

- reprocessabilité à chaud, ou capacité du polymère à fluer à une température supérieure à la température de fusion du polyoléfine initial,
- délaminabilité / relaminabilité,
- perméabilité à l'eau inférieure à 15 g/$m^2$/jour mais préférentiellement inférieure à 10 g/$m^2$/jour et encore plus préférentiellement inférieure à 5 g/$m^2$/jour,
- transmission optique supérieure à 85% dans la gamme 280-1200 nm, de préférence supérieure à 90% dans la gamme 280-1200 nm,
- point de coupure ou cut-off en anglais inférieur à 375nm,

L'encapsulant de l'invention doit avant tout être comparé aux résines thermoplastiques connus et utilisées comme encapsulant, qui sont développées pour permettre la recyclabilité des panneaux photovoltaïques. Plusieurs défauts de résines thermoplastiques de l'état de la technique ont été notés :

- L'utilisation d'autres systèmes de polymère que l'EVA, souvent moins performant (mécanique, optique, stabilité UV). La recyclabilité du système compense cette perte de performance au global, mais le cas idéal consisterait à avoir les propriétés de l'EVA réticulé, avec la démontabilité d'un thermoplastique.
- La viscosité à chaud des résines thermoplastiques utilisées qui reste élevée et est susceptible de nécessiter des traitements chimiques (solvants) pour efficacement retirer le polymère de l'ensemble des éléments des panneaux recyclés (substrat verre, modules photovoltaïques).
- La nécessité dans certains cas, pour pallier au manque de propriétés des couches thermoplastiques, d'ajouter malgré tout une couche d'EVA réticulé, entre les couches permettant la séparation, ce qui complexifie l'assemblage et rend complexe le recyclage et nettoyage de chaque constituant de l'assemblage. Le démontage est facilité mais il reste des résidus d'EVA sur les différents composants du panneau.

L'encapsulant de l'invention présente l'avantage de permettre une séparation aisée des constituants des panneaux photovoltaïques tout en conservant l'utilisation de résines à bas coût, mais sans compromis sur les propriétés en utilisation comparé à l'EVA.

On peut également envisager un procédé de relamination des panneaux en cas de délamination entre le verre et l'encapsulant ou d'impacts structurels du verre. Par exemple, si des panneaux sont impactés par un orage de grêle et que le verre de protection est fissuré, on peut envisager un remplacement du verre tout en gardant le reste de la structure du panneau intacte.

Elle permet également une économie d'énergie lors de la lamination de l'assemblage, la formation du réseau polymère ayant déjà été effectuée au préalable. On peut envisager une optimisation du procédé de lamination avec une diminution des températures de lamination par rapport aux recettes traditionnelles utilisées pour l'EVA.

Les modules photovoltaïques avec les encapsulants EVA sont généralement laminés à une température de 160°C pour permettre la réticulation *in situ* par les peroxydes. Les conditions de lamination à température plus basse avec les encapsulants de l'invention pourraient être un avantage pour l'encapsulation de cellules photovoltaïques plus fragiles et se dégradant en température (par exemple cellule tandem avec couche de pérovskite).

De plus, la formation du réseau polyoléfinique est faite au préalable par décomposition de peroxyde. Le contrôle de la décomposition de ces initiateurs de radicaux (peroxydes) est plus aisé. De plus, pour la formulation finale, l'incorporation des absorbeurs UV, inhibiteurs de radicaux, promoteurs d'adhésion, etc. peut se faire après la formation du réseau polyoléfinique. Ceux-ci n'interfèrent donc pas avec la réaction de formation du réseau et donc ne vont pas bloquer les réactions radicalaires.

L'invention a également pour objet, l'utilisation d'un encapsulant l'invention, dans un module photovoltaïque.

L'utilisation d'un polyoléfine de formule (I) réticulé via une chimie dynamique covalente dans la composition de l' encapsulant dans les modules photovoltaïques, facilite le démantèlement et le recyclage des différents composants du panneau.

Un autre objet de l'invention est un module photovoltaïque comprenant

- un substrat transparent, correspondant souvent à un verre solaire présentant les caractéristiques suivantes : une faible réflexion, une haute transmissivité et une haute résistance.
  Les verres utilisés sont soit des verres cristallins (mono ou polycrystallins), soit des verres à couches minces. Les verres sont parfois recouverts d'un revêtement afin de diminuer leur réflexion et à faible teneur en fer (Fe), afin d'obtenir des valeurs de transparences élevées connues sous le nom de verre à faible teneur en fer ou verre ultra-blanc,
- une couche d'encapsulant selon l'invention,
- une cellule photovoltaïque, notamment à base de silicium, de séléniure de cuivre-indium ($CuIn(Se)_2$, ou CIS), de séléniure de cuivre, indium et de gallium ($CuInGa(Se)_2$, aussi appelé CIGS), ou de tellure de cadmium (CdTe),
- une autre couche d'encapsulant selon l'invention,
- une couche protectrice supportant le tout (backsheet), notamment en polyfluorure de vinylidène (PVDF), poly(oxyde de p-phénylène) (PPO) ou poly(éther de p-phénylène) (PPE), poly(téréphtalate

d'éthylène) (PET), chlorure de polyvinyle (PVC), ou élastomère thermoplastique (TPE) ou en verre.

Les élastomères thermoplastiques peuvent être choisis parmi le TPA, le TPC, le TPO, le TPS, le TPU et le TPV. Une vue d'ensemble des élastomères thermoplastiques peut être trouvée dans « Elastomères Thermoplastiques » (Biron, M. (2000). Elastomeres Thermoplastiques (TPE). Ed. Techniques Ingénieur).

**EXEMPLES**

Deux exemples de réalisation sont donnés ci-dessous.

Le polyéthylène a été acheté chez DOW® (référence PV Engage 8669). Le peroxyde de dicumyle, l'anhydride maléique et le trimethylsilanolate de potassium ont été acheté chez sigma-aldrich®. Le polydiméthylsiloxane à terminaisons vinyliques a été acheté chez Gelest® (référence DMS-V03). Le 1,3-bis(3-aminopropyl)tétraméthyldisiloxane a été acheté chez ABCR. Le xylène a été acheté chez Carlo Erba.

<u>**Exemple 1**</u> :

45 g polyéthylène ayant un IFC (Indice de Fluidité à Chaud) ou MFI (Melt Flow Index an anglais) =14g/10min (190°C, 2,16kg, ASTM D1238) sont placés dans la chambre d'un mélangeur interne HAAKE™ Rheomix QC50 mis sur une plateforme HAAKE™ PolyLab QC(Thermo Scientific™) d'un volume interne de 70 $cm^3$ et mis en mélange à 90°C, sous agitation à 30 tr/min jusqu'à obtenir un couple stable. L'étape de greffage du polydiméthylsiloxane à terminaisons vinyliques appelé également PDMS divinylique (500g.$mol^{-1}$) est ensuite effectué en ajoutant au mélange 1,5g de ce composé et 95mg de peroxyde de dicumyle appelé également DCP. Si un catalyseur est ajouté au mélange, l'ajout est effectué également à cet instant. Une étape de mélange est effectuée à 90°C pendant 10 à 15min afin d'obtenir un mélange homogène. Puis la température de consigne du mélangeur interne est portée à 165°C (afin d'obtenir une température maximale dans le mélangeur de 175°C, échauffement dû aux frottements et à la réaction de décomposition radicalaire du peroxyde). Le mélange est poursuivi 10 minutes lorsque la température de consigne est atteinte dans le mélangeur pour laisser à la réaction le temps de se faire (décomposition des peroxydes pour la génération des radicaux). Le mélangeur est ensuite stoppé et le polymère peut être récupéré.

Le matériau est ensuite mis en forme de plaque d'environ 1mm d'épaisseur via une presse CARVER 3850CE chauffée à 150°C, la pression appliquée est de 3 tonnes sur une surface de 22 cm par 22 cm. La plaque obtenue peut être utilisée comme encapsulant de petits modules photovoltaïque (cellules et plaque de verre de 20 x 20 cm) en les plaçant en compression dans l'ordre verre, polymère, cellules, polymère, backsheet à 160°C durant 16 minutes. Le module ainsi obtenu peut-être démantelé en chauffant le système à 150°C et en décollant le verre du module encapsulé.

<u>**Exemple 2**</u>

Dans un deuxième exemple, la réaction de greffage du PDMS divinylique est remplacée par une réaction de greffage d'anhydride maléique. Le polymère fonctionnalisé est ensuite réticulé avec le 1,3-bis(3-aminopropyl)tétraméthyldisiloxane. La première étape consiste à placer 45 g de polyéthylène (appelé également PE) ayant un IFC=14g/10min (190°C, 2,16kg, ASTM D1238) dans la chambre d'un mélangeur interne HAAKE™ Rheomix QC50 mis sur une plateforme HAAKE™ PolyLab QC(Thermo Scientific™) d'un volume interne de 70 $cm^3$ et mis en mélange à 130°C, sous une agitation de 30 tr/min jusqu'à obtenir un couple stable. 0,6 g d'anhydride maléique sont ensuite placés dans le mélangeur interne puis 23 mg d'un activateur radicalaire, présentement le peroxide de dicumyle sont ajoutés et laissés sous agitation pendant 10 min. La température de consigne est ensuite portée à 175°C et le milieu est laissé à réagir pendant 10 min une fois la température de consigne atteinte. L'étape de réticulation est réalisée en voie solvant. Le polymère fonctionnalisé est solubilisé dans du xylène à chaud (110°C) à hauteur de 10% en masse en polymère. Le 1,3-bis(3-aminopropyl)tétraméthyldisiloxane est ensuite ajouté (quantité calculé à partir du taux de fonctionnalisation du PE pour être de 1 équivalent molaire en terme de fonctions) au milieu réactionnel. La gélification du milieu apparaît en quelques minutes. Le xylène est ensuite évaporé. Le séchage se fait en étuve sous vide afin déplacer complètement l'équilibre de réaction entre les fonctions anhydrides maléiques et les fonctions amines. Suite à cette étape de séchage, le polymère est remis en forme sous forme de film pour pouvoir ensuite être utilisé comme encapsulant dans des panneaux photovoltaïques.

<u>**Tests et mesures**</u>

<u>Analyse mécanique dynamique (AMD) et mesure du taux de gonflement du polymère obtenu dans l'exemple 1</u>

La méthode de mesure Analyse mécanique dynamique (AMD) appelé également Dynamic Mechanical Analysis (DMA) en anglais, est une mesure de la viscoélasticité qui montre l'obtention d'un réseau polymère. L'appareil utilisé est une DMA Q800 de chez TA Instrument®.

[Fig.7] montre les courbes ADM (à gauche) et les résultats des tests de gonflement (taux de gonflement et fraction insoluble) (à droite) après 48 heures à 110°C dans du xylène du polymère obtenu dans l'exemple 1 sans catalyseur et avec 0,1 mol% de catalyseur (par

rapport aux fonctions Si-O). Le taux d'insoluble (masse de polymère non solubilisée après traitement dans le xylène à 110°C, 48h, divisée par la masse totale d'échantillon exprimée en pourcentage) est proche de 50%. Le module élastique est supérieur au module de perte au niveau du plateau caoutchoutique.

Ces deux résultats confirment l'obtention d'un réseau polymère dans les encapsulants selon l'invention.

Test de fluage avec l'encapsulant de l'exemple 1

L'appareil utilisé pour le test de fluage est une DMA Q800 de chez TA Instrument®.

Le test de fluage a été conduit à 140°C en imposant une contrainte constante de 1000 Pa pendant 30 minutes et relâchant les contraintes pendant une période de 30 minutes et en mesurant dans le même temps la déformation du matériau au cours du temps. Le test décrit correspond à un cycle et le matériau a subi 6 cycles successifs.

[Fig.8] montre le résultat de fluage recouvrance du matériau de l'exemple 1 (avec ou sans catalyseur) (condition du fluage : $\sigma$=1000 Pa, temps de fluage: 30 min, temps de recouvrance : 30 min, nombre de cycles : 6). Le matériau ne recouvre pas intégralement son pourcentage de déformation, il a donc flué.

Le test de fluage ainsi que la reprocessabilité des matériaux à chaud malgré la présence d'un réseau confirme la dynamique des points de réticulation.

Mesures de propriétés optiques par transmittance avec l'encapsulant de

l'exemple 1

Des mesures optiques des encapsulants ont été réalisés en utilisant l'équipement suivant : BYK Haze Gard i.

Cet équipement permet de donner des valeurs de transmission totale **T,** haze (turbidité) **H,** et clarté **C**.

Les résultats sont regroupés dans le tableau 2 :

- avec catalyseur (0,1mol% par rapport aux fonction Si-O) : échantillons BA61
- sans catalyseur : échantillons BA29

Les mesures ont été réalisées 5 fois sur le même film mais en changeant la zone de mesure.

Tableau 2 :

| | T | H | C |
|---|---|---|---|
| BA29 | 88,6 | 25,4 | 57,2 |
| | 89 | 26,2 | 57,3 |
| | 89 | 27,6 | 58,4 |
| | 88,9 | 26,6 | 56 |
| | 88,6 | 31,5 | 54,7 |
| BA61 | 90,4 | 28,2 | 20,2 |
| | 90,2 | 23,9 | 39,1 |
| | 89,9 | 25,5 | 40,5 |
| | 89,9 | 24,5 | 42,8 |
| | 89,3 | 31,5 | 35,5 |

Les valeurs données de transmission T, haze H et clarté C sont données en %.

La transmission totale T est définie par le rapport entre l'intensité lumineuse transmisse totale $I_{TT}$ et l'intensité lumineuse incidente $I_I$.

$$T = 100\% \times I_{TT} / I_I$$

Cette valeur permet d'évaluer la part de lumière réfléchie ou absorbée par l'échantillon.

La valeur de haze H permet de mesurer la part de lumière transmise qui s'écarte du faisceau incident de plus de 2,5° en moyenne. Elle est définie par le rapport entre l'intensité diffusée à un angle supérieur à 2,5° $I_{Diff}$ et l'intensité transmise totale.

$$Haze = 100\% \times I_{Diff} / I_{TT}$$

La valeur de clarté C permet d'évaluer la quantité de diffusion à angle étroit. Il s'agit d'un calcul plus complexe qui permet d'évaluer la quantité d'intensité lumineuse diffusé à un angle inférieur à 2.5° $I_R$ par rapport à l'intensité lumineuse non diffusé et donc transmise de manière parallèle au rayon incident $I_C$.

$$C = 100\% \times (I_C - I_R) / (I_C + I_R)$$

Une valeur de 100% correspond à un cas de figure où il n'y a pas de lumière diffusée.

Une valeur de 0% correspond à un cas de figure où l'intensité de la lumière diffusée $I_R$ est égale à l'intensité de lumière incidente $I_C$.

Lamination/délamination/relamination des assemblages verre/encapsulant/couche protectrice supportant le tout ou backsheet

Un test de lamination/délamination/relamination a été effectué pour démontrer le potentiel de ce type

d'encapsulant pour allonger la durée de vie des panneaux solaires ou faciliter leur démontabilité en fin de vie.

**Etape 1** :

Un assemblage verre (carré de 8cm sur 8cm)/encapsulant/backsheet a été préparé par lamination sous presse hydraulique pendant 20 min à 150°C sous une pression de environ 400kg. L'adhésion du basksheet au verre grâce à la présence de l'encapsulant a été démontrée en faisant supporter un poids de 7 kg à l'ensemble.

**Etape 2** :

Cet assemblage est ensuite placé à 150°C pendant 10 minutes sans appliquer de pression. Le bicouche « backsheet + encapsulant » a pu être retiré facilement à la main du verre solaire. Le verre solaire présente très peu de traces de polymères résiduels.

**Etape 3** :

L'assemblage a été reformé par lamination à chaud (20 min à 150°C sous 400kg) des deux parties délaminées précédemment (verre solaire et « backsheet + encapsulant »). L'adhésion a de nouveau été démontré en faisant supporter un poids de 7 kg à l'ensemble.

L'ensemble de ces étapes est décrit en [Fig.9] regroupant les différentes étapes sous forme de photographies.

## Revendications

1. Encapsulant de module photovoltaïque, **caractérisé en ce qu'**il comprend,

   - un polyoléfine formule (I)

   [Chem 1]

   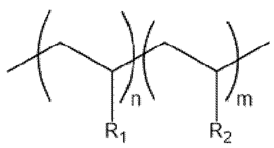

   dans laquelle

   n = 1 à 100%,
   m = (100 - n)%,
   $R_1$ et $R_2$, identiques ou différents, représentent un atome d'hydrogène, un groupe alkyle comportant 1 à 12 atomes de carbone, un groupe cycloalkyle comportant 3 à 12 atomes de carbone, les groupes alkyle, cycloalkyle étant éventuellement substitués,

   ledit polyoléfine ayant

   . un indice de fluidité à chaud (appelé également IFC) supérieur à 0,1 g/10min et inférieur à 50g/10min (norme iso 1133-1 (2011)), 190°C, 2,16 Kg), et
   . un taux de cristallinité massique inférieur à 30% ;

   - un groupe dialkylsiloxane choisi parmi le diméthylsiloxane et le diéthylsiloxane, et/ou le polydialkylsiloxane de formule (II) :

   [Chem 2]

   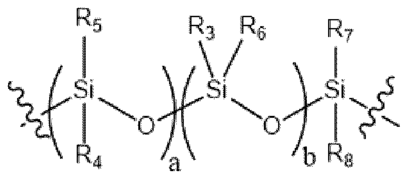

   dans laquelle

   . a = 1 à 100%,
   . b = (100 - a)%, et
   . le nombre d'unité de répétition Si-O-Si est compris entre 1 (dialkylsiloxane) et 5000,
   . $R_3$ représente un groupe méthyle, un groupe éthyle ou

   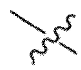

   qui est le point d'attache de $R_3$ au polyoléfine par une liaison covalente,
   . $R_4$, $R_5$, $R_6$, $R_7$,et $R_8$, identiques ou différents, représentent un groupe méthyle ou un groupe éthyle,

   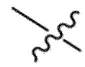

   représente le point d'attache du polydialkylsiloxane au polyoléfine par une liaison covalente,
   comme réticulant ;

   le polyoléfine représentant de 78 à 99,75% en masse, le réticulant de 0,25 à 22% en masse par rapport à la masse totale de la composition de l'encapsulant.

2. Encapsulant selon la revendication 1, **caractérisé en ce que** le polyoléfine de formule (I), est choisi parmi

le polyéthylène basse densité linéaire (PEBDL ou LLDPE de Linear low-density polyethylene en anglais),
le polyéthylène à basse densité (PEBD ou LDPE de low density polyethylene en anglais),

- le polypropylène (PP).

**3.** Encapsulant selon l'une des revendications 1 ou 2, **caractérisé en ce que** le précurseur du groupe disiloxane est choisi parmi le 1,3-bis(3-glycidyloxypropyl) tétraméthyldisiloxane, le 1,3-divinyltétraméthyldisiloxane, le 1,3-bis(3-aminopropyl)tétraméthyldisiloxane, le 1,3-diallyltétraméthyldisiloxane, le 1,3-bis(chloropropyl)tétramethyldisiloxane, le 1,3-bis(hydroxypropyl)tétraméthyldisiloxane, dont le greffage aboutit à un polyalkylsiloxane de formule (II)

[Chem 3]

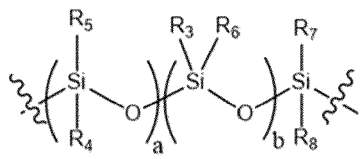

dans laquelle

. a = 1 à 100%,
. b = (100 - a)%, et
. le nombre d'unité de répétition Si-O-Si est compris entre 1 (dialkylsiloxane) et 5000,
. $R_3$ représente un groupe méthyle, un groupe éthyle ou

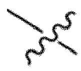

qui est le point d'attache de $R_3$ au polyoléfine par une liaison covalente,
. $R_4$, $R_5$, $R_6$, $R_7$,et $R_8$, identiques ou différents, représentent un groupe méthyle ou un groupe éthyle,
.

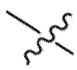

représente le point d'attache du polydialkylsiloxane au polyoléfine par une liaison covalente.

**4.** Encapsulant selon l'une quelconque des revendications 1 à 3, **caractérisé en ce que** le réticulant représente de 0,25 à 10% en masse, par rapport à la masse totale de la composition de l'encapsulant.

**5.** Encapsulant selon l'une quelconque des revendications 1 à 4, **caractérisé en ce que** le réticulant représente de 1 à 10% en masse par rapport à la masse totale de la composition de l'encapsulant.

**6.** Encapsulant selon l'une quelconque des revendications 1 à 5, **caractérisé en ce qu'**il comprend au sein du polyoléfine ou greffée sur le polyoléfine, un catalyseur choisi parmi

- une base organique à base d'amine ternaire choisi dans le groupe consistant en le 1,5,7-triazabicyclo[4.4.0] dec-5-ène, le 1,5-diazabicyclo[4.3.0]non-5-ènsilanolate,8-diazabicyclo [5.4.0]undec-7-ène, le 1,4-diazabicyclo[2.2.2] octane, et la 1,1,3,3-tétraméthylguanidine ;
- un ammonium quaternaire choisi dans le groupe consistant en l'hydroxyde de tétraméthylammonium et les silanolates de tétraméthylammonium ;
- une base choisi dans le groupe consistant en KOH, triméthylsilalonate de potassium ;
- un acide de Lewis choisi parmi les sels métalliques tels que le trifluorométhanesulfonate de zinc (également appelé triflate de zinc) ou le trifluorométhanesulfonate de scandium (également appelé triflate de scandium).

**7.** Encapsulant selon la revendication 6, **caractérisé en ce que** le chargement en catalyseur va jusqu'à 10 % en masse du polyoléfine de formule (I).

**8.** Encapsulant selon l'une quelconque des revendications 1 à 7, **caractérisé en ce que** l'encapsulant comprend, en outre, des additifs choisis dans le groupe consistant en des promoteurs d'adhésion, des antioxydants, des absorbeur d'UV.

**9.** Utilisation d'un encapsulant selon l'une quelconque des revendications 1 à 8 dans un module photovoltaïque.

**10.** Module photovoltaïque comprenant

- un substrat transparent, correspondant à un verre solaire, un verre cristallin (mono ou polycristallin), un verre à couche mince, ou un verre ultra-blanc,
- une couche d'encapsulant selon l'invention,
- une cellule photovoltaïque, notamment à base de silicium, de séléniure de cuivre-indium ($CuIn(Se)_2$, ou CIS), de séléniure de cuivre, indium et de gallium ($CuInGa(Se)_2$, aussi appelé CIGS), ou de tellure de cadmium (CdTe),
- une autre couche d'encapsulant selon l'invention,
- une couche protectrice supportant le tout (backsheet), en polyfluorure de vinylidène

(PVDF), poly(oxyde de p-phénylène) (PPO) ou poly(éther de p-phénylène) (PPE), poly(téréphtalate d'éthylène) (PET), chlorure de polyvinyle (PVC), ou élastomère thermoplastique (TPE) ou en verre.

[Fig.1]

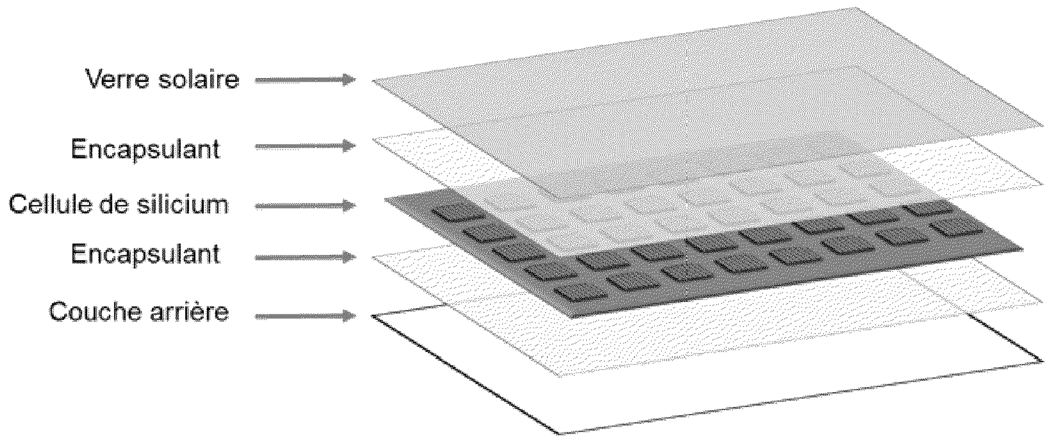
Verre solaire
Encapsulant
Cellule de silicium
Encapsulant
Couche arrière

[Fig.2]

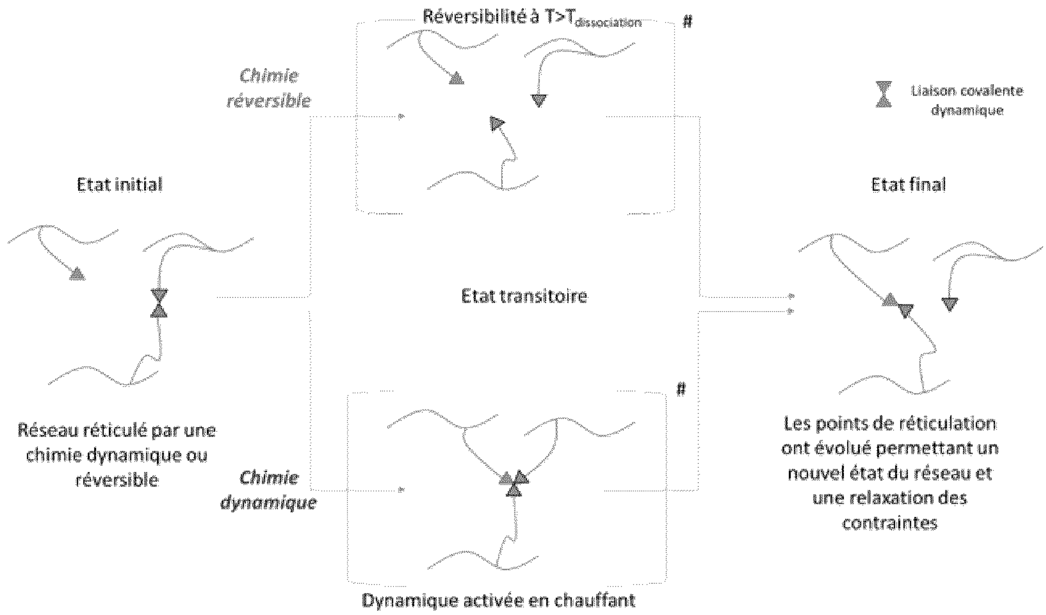
Réversibilité à T>T dissociation
#
Chimie réversible
Liaison covalente dynamique
Etat initial
Etat final
Etat transitoire
#
Réseau réticulé par une chimie dynamique ou réversible
Chimie dynamique
Les points de réticulation ont évolué permettant un nouvel état du réseau et une relaxation des contraintes
Dynamique activée en chauffant

[Fig.3]

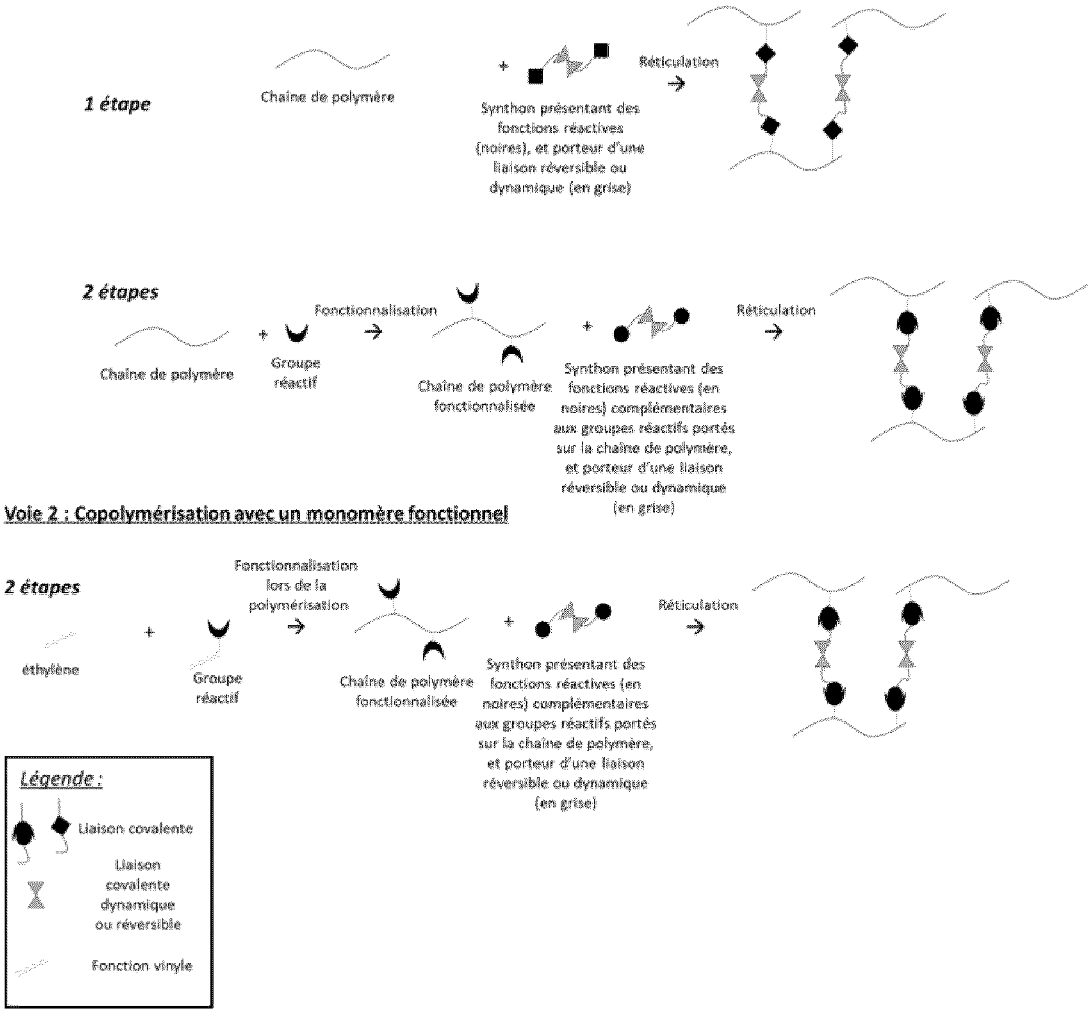
1 étape
Chaine de polymère
+
Synthon présentant des fonctions réactives (noires), et porteur d'une liaison réversible ou dynamique (en grise)
Réticulation
2 étapes
Chaine de polymère
+
Groupe réactif
Fonctionnalisation
Chaine de polymère fonctionnalisée
+
Synthon présentant des fonctions réactives (en noires) complémentaires aux groupes réactifs portés sur la chaîne de polymère, et porteur d'une liaison réversible ou dynamique (en grise)
Réticulation
Voie 2 : Copolymérisation avec un monomère fonctionnel
2 étapes
éthylène
+
Groupe réactif
Fonctionnalisation lors de la polymérisation
Chaine de polymère fonctionnalisée
+
Synthon présentant des fonctions réactives (en noires) complémentaires aux groupes réactifs portés sur la chaîne de polymère, et porteur d'une liaison réversible ou dynamique (en grise)
Réticulation
Légende :
Liaison covalente
Liaison covalente dynamique ou réversible
Fonction vinyle

[Fig.4]

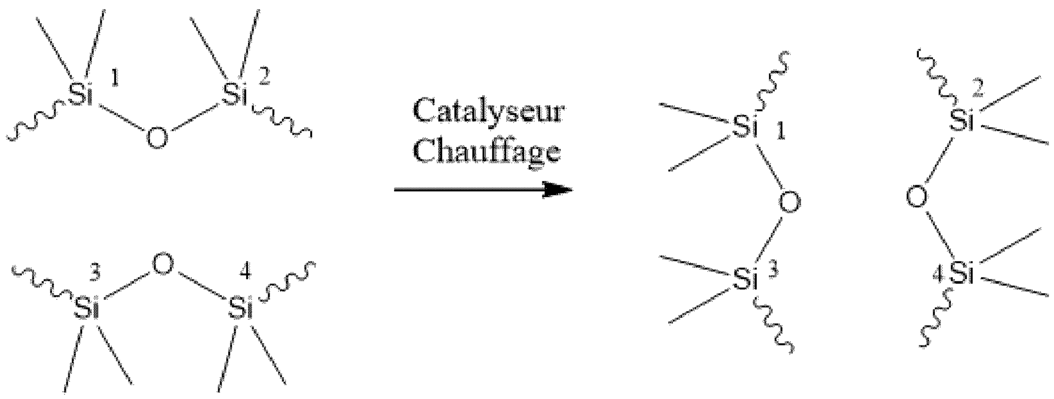


[Fig.5]

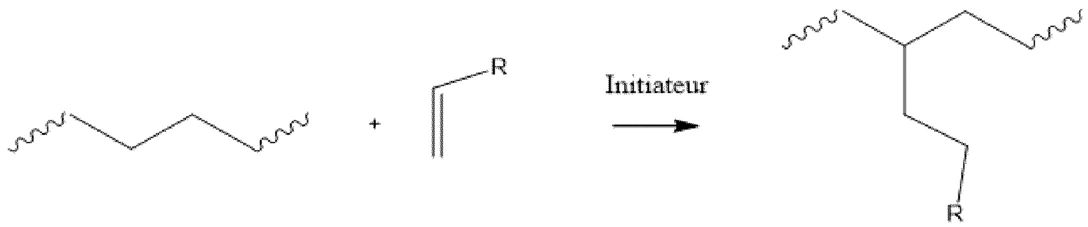


[Fig.6]

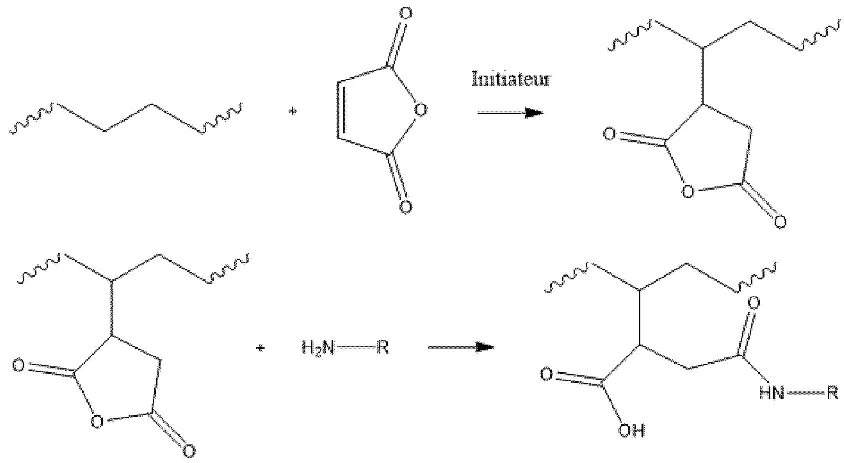

[Fig.7]

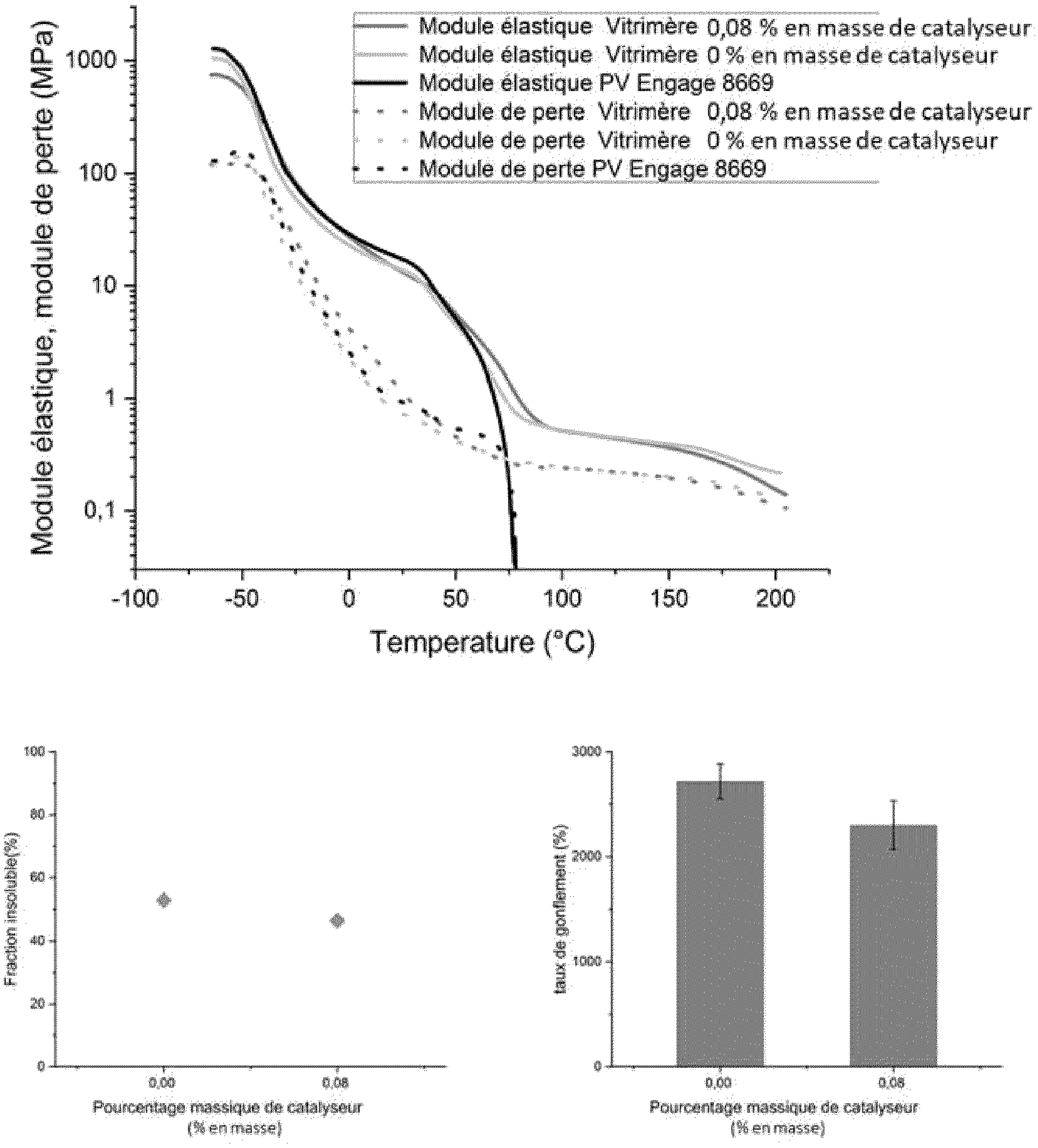
Module élastique Vitrimère 0,08 % en masse de catalyseur
Module élastique Vitrimère 0 % en masse de catalyseur
Module élastique PV Engage 8669
Module de perte Vitrimère 0,08 % en masse de catalyseur
Module de perte Vitrimère 0 % en masse de catalyseur
Module de perte PV Engage 8669
Module élastique, module de perte (MPa)
1000
100
10
1
0,1
-100
-50
0
50
100
150
200
Temperature (°C)
Fraction insoluble(%)
100
80
60
40
20
0
0,00
0,08
Pourcentage massique de catalyseur
(% en masse)
taux de gonflement (%)
3000
2000
1000
0
0,00
0,08
Pourcentage massique de catalyseur
(% en masse)

[Fig.8]

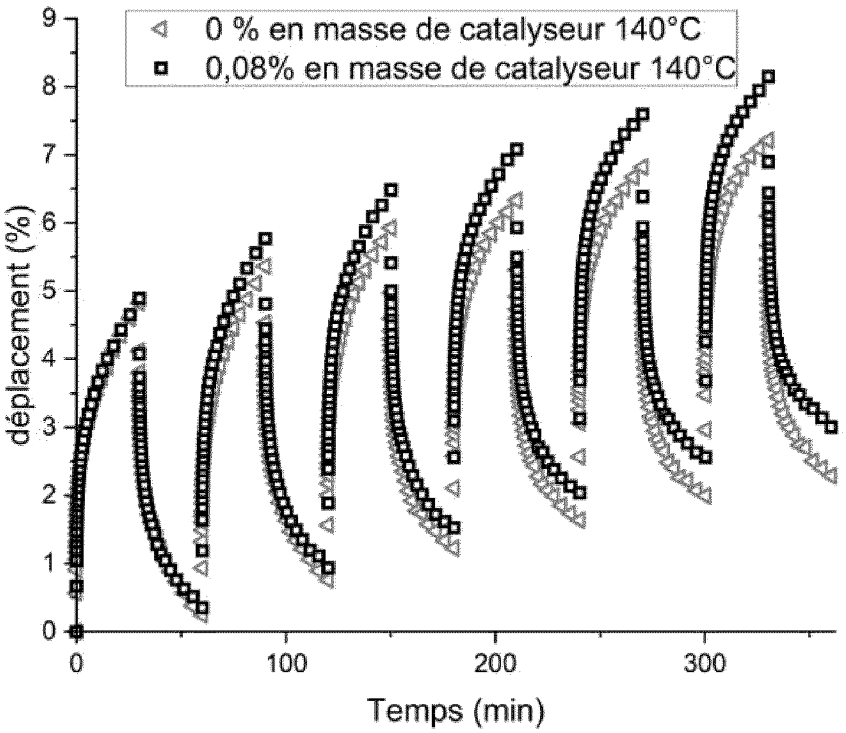
0 % en masse de catalyseur 140°C
0,08% en masse de catalyseur 140°C
déplacement (%)
Temps (min)
0
1
2
3
4
5
6
7
8
9
0
100
200
300

[Fig.9]

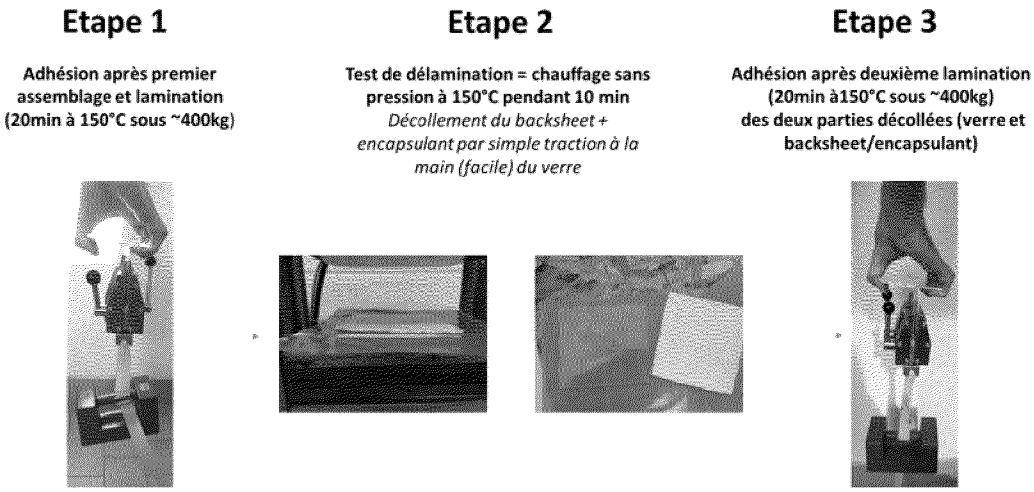
Etape 1
Adhésion après premier assemblage et lamination (20min à 150°C sous ~400kg)
Etape 2
Test de délamination = chauffage sans pression à 150°C pendant 10 min
Décollement du backsheet + encapsulant par simple traction à la main (facile) du verre
Etape 3
Adhésion après deuxième lamination (20min à150°C sous ~400kg) des deux parties décollées (verre et backsheet/encapsulant)

Europäisches Patentamt
European Patent Office
Office européen des brevets

# RAPPORT DE RECHERCHE EUROPEENNE

Numéro de la demande
EP 25 15 4659

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X<br><br><br>A | WO 2023/272545 A1 (DOW GLOBAL TECHNOLOGIES LLC [US]; SUN YABIN [CN] ET AL.) 5 janvier 2023 (2023-01-05)<br>* le document en entier *<br>----- | 1,3-10<br><br><br>2 | INV.<br>B32B27/32<br>C08F255/02<br>C08F10/02<br>C08J3/24 |
| X | CN 115 724 875 A (HANGZHOU FIRST APPLIED MAT CO LTD) 3 mars 2023 (2023-03-03)<br>* le document en entier *<br>----- | 1,3-10 | |
| X<br><br><br>A | WO 2019/000744 A1 (DOW GLOBAL TECHNOLOGIES LLC [US]; HE CHAO [CN] ET AL.) 3 janvier 2019 (2019-01-03)<br>* le document en entier *<br>----- | 1,3-10<br><br><br>2 | |
| X,P | WO 2024/197770 A1 (DOW GLOBAL TECHNOLOGIES LLC [US]; SUN YABIN [CN] ET AL.) 3 octobre 2024 (2024-10-03)<br>* le document en entier *<br>----- | 1-10 | |

| DOMAINES TECHNIQUES RECHERCHES (IPC) |
|---|
| C08F<br>B32B<br>H01L<br>C08J |

Le présent rapport a été établi pour toutes les revendications

2

| Lieu de la recherche | Date d'achèvement de la recherche | Examinateur |
|---|---|---|
| Munich | 10 juin 2025 | Balmer, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................................................
& : membre de la même famille, document correspondant

EPO FORM 1503 03.82 (P04C02)

# ANNEXE AU RAPPORT DE RECHERCHE EUROPEENNE RELATIF A LA DEMANDE DE BREVET EUROPEEN NO.

EP 25 15 4659

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-06-2025

| Document brevet cité au rapport de recherche | Date de publication | Membre(s) de la famille de brevet(s) | Date de publication |
|---|---|---|---|
| WO 2023272545 A1 | 05-01-2023 | BR 112023025744 A2 | 27-02-2024 |
| | | CN 117580875 A | 20-02-2024 |
| | | EP 4363464 A1 | 08-05-2024 |
| | | JP 2024526140 A | 17-07-2024 |
| | | KR 20240027028 A | 29-02-2024 |
| | | US 2024218154 A1 | 04-07-2024 |
| | | WO 2023272545 A1 | 05-01-2023 |
| CN 115724875 A | 03-03-2023 | AUCUN | |
| WO 2019000744 A1 | 03-01-2019 | BR 112019025731 A2 | 23-06-2020 |
| | | BR 112019025964 A2 | 30-06-2020 |
| | | BR 112019026356 A2 | 21-07-2020 |
| | | BR 112019026362 A2 | 21-07-2020 |
| | | CA 3068492 A1 | 03-01-2019 |
| | | CA 3068494 A1 | 03-01-2019 |
| | | CA 3068495 A1 | 03-01-2019 |
| | | CN 110770288 A | 07-02-2020 |
| | | CN 110770289 A | 07-02-2020 |
| | | CN 110785463 A | 11-02-2020 |
| | | CN 110809602 A | 18-02-2020 |
| | | CN 116003896 A | 25-04-2023 |
| | | EP 3645617 A1 | 06-05-2020 |
| | | EP 3645618 A1 | 06-05-2020 |
| | | EP 3645619 A1 | 06-05-2020 |
| | | EP 3645629 A1 | 06-05-2020 |
| | | JP 7061141 B2 | 27-04-2022 |
| | | JP 7065892 B2 | 12-05-2022 |
| | | JP 7080908 B2 | 06-06-2022 |
| | | JP 7169310 B2 | 10-11-2022 |
| | | JP 7368538 B2 | 24-10-2023 |
| | | JP 7429267 B2 | 07-02-2024 |
| | | JP 2020525565 A | 27-08-2020 |
| | | JP 2020525566 A | 27-08-2020 |
| | | JP 2020525569 A | 27-08-2020 |
| | | JP 2020531595 A | 05-11-2020 |
| | | JP 2022109990 A | 28-07-2022 |
| | | JP 2022172160 A | 15-11-2022 |
| | | KR 20200024230 A | 06-03-2020 |
| | | KR 20200024231 A | 06-03-2020 |
| | | KR 20200024232 A | 06-03-2020 |
| | | KR 20200024843 A | 09-03-2020 |
| | | KR 20230113666 A | 31-07-2023 |
| | | MY 199669 A | 15-11-2023 |
| | | RU 2020101336 A | 15-07-2021 |
| | | TW 201905056 A | 01-02-2019 |

EPO FORM P0460

Pour tout renseignement concernant cette annexe : voir Journal Officiel de l'Office européen des brevets, No.12/82

## ANNEXE AU RAPPORT DE RECHERCHE EUROPEENNE RELATIF A LA DEMANDE DE BREVET EUROPEEN NO.

EP 25 15 4659

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-06-2025

| Document brevet cité au rapport de recherche | Date de publication | Membre(s) de la famille de brevet(s) | Date de publication |
|---|---|---|---|
| | | TW 201905061 A | 01-02-2019 |
| | | TW 202012524 A | 01-04-2020 |
| | | US 2020199270 A1 | 25-06-2020 |
| | | US 2020199309 A1 | 25-06-2020 |
| | | US 2020199340 A1 | 25-06-2020 |
| | | US 2022098337 A1 | 31-03-2022 |
| | | US 2023002523 A1 | 05-01-2023 |
| | | US 2024279437 A1 | 22-08-2024 |
| | | WO 2019000311 A1 | 03-01-2019 |
| | | WO 2019000654 A1 | 03-01-2019 |
| | | WO 2019000744 A1 | 03-01-2019 |
| | | WO 2019001206 A1 | 03-01-2019 |
| WO 2024197770 A1 | 03-10-2024 | AUCUN | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description


- The synthesis of polyolefin graft copolymers by reactive extrusion. *Prog. Polym. Sci.*, 1999, vol. 24, 81-142
- Elastomères Thermoplastiques. **BIRON, M**. Elastomeres Thermoplastiques (TPE). Ed. Techniques Ingénieur, 2000